Europäisches Patentamt

European Patent Office

Office européen des brevets

(11) Veröffentlichungsnummer: **0 403 733**
**A1**

## EUROPÄISCHE PATENTANMELDUNG

(21) Anmeldenummer: **90104606.0**

(22) Anmeldetag: **12.03.90**

(51) Int. Cl.5: **H03K 17/95, H03B 5/12**

(30) Priorität: **20.06.89 DE 3920051**

(43) Veröffentlichungstag der Anmeldung:
**27.12.90 Patentblatt 90/52**

(84) Benannte Vertragsstaaten:
**AT BE CH DE FR GB IT LI NL SE**

(71) Anmelder: **Euchner & Co.**
**Kohlhammerstrasse 16**
**D-7022 Leinfelden-Echterdingen(DE)**

(72) Erfinder: **Link, Walter Dr. Ing.**
**Beethovenstrasse 13**
**D-7522 Rutesheim(DE)**
Erfinder: **Grübel, Harald Dr. Ing.**
**Kirschenweg 3/2**
**D-7255 Rutesheim(DE)**
Erfinder: **Quinzio, Giovanni Dipl. Ing.**
**Eisbärenstrasse 18**
**D-7000 Stuttgart 80(DE)**

(74) Vertreter: **Patentanwälte Phys. Bartels**
**Dipl.-Ing. Fink Dr.-Ing. Held**
**Lange Strasse 51**
**D-7000 Stuttgart 1(DE)**

(54) Oszillator, insbesondere für einen berührungslos arbeitenden induktiven Näherungssensor oder Näherungsschalter.

(57) Bei einem Oszillator, mit einem eine Induktivität (L) und eine Kapazität (Cp) aufweisenden Schwingkreis (1) und einem Rückkopplungstransistor (T), dessen Kollektor-Emitter-Strecke in Reihe mit dem Schwingkreis (1) liegt, liegt der auch als Verstärkertransistor dienende Rückkopplungstransistor (T) zwischen dem Schwingkreis (1) und einem Gegenkopplungsnetzwerk (2). Die Reihenschaltung aus dem Schwingkreis (1), dem Rückkopplungstransistor (T) und dem Gegenkopplungsnetzwerk (2) liegt zwischen den Anschlußklemmen für die Betriebsspannung (UB), die Basis des Rückkopplungstransistors (T) an einer den Arbeitspunkt bestimmenden Gleichspannung (Uo). Die Oszillator-Ausgangsspannung (UA) wird an der Reihenschaltung aus der Kollektor-Emitter-Strecke des Rückkopplungstransistors (T) und des Gegenkopplungsnetzwerkes (2) abgegriffen.

Fig.1

## Oszillator, insbesondere für einen berührungslos arbeitenden induktiven Näherungssensor oder Näherungsschalter

Die Erfindung betrifft einen Oszillator, welcher die Merkmale des Oberbegriffs des Anspruches 1 aufweist.

Es sind eine Reihe unterschiedlicher Oszillatoren bekannt, welche für berührungslos arbeitende, induktive Näherungsschalter verwendet werden. Zu diesen Oszillatoren gehört der sogenannte Hartley-Oszillator, der eine Mittelanzapfung der Schwingkreisspule hat. Die Fertigung einer solchen Spule ist aufwendig. Außerdem hat sie drei Lötpunkte, welche nicht verwechselt werden dürfen. Der sogenannte Colpitts-Oszillator, der ebenfalls für Näherungsschalter der in Rede stehenden Art verwendet wird, benötigt zwei temperaturstabile Schwingkreiskondensatoren und ist deshalb ebenfalls aufwendig. Eine aufwendige Schaltungstechnik mit vielen Transistoren weist der sogenannte NEGATIVE IMPEDANCE CONVERTER auf, der ebenfalls als Oszillator für berührungslos arbeitende induktive Näherungsschalter geeignet ist.

Verhältnismäßig aufwendig ist auch ein bekannter Oszillator der eingangs genannten Art (DE 35 19 714 A1) da er außer einem Oszillatortransistor und einem Rückkopplungstransistor noch zwei weitere Transistoren zum Zwecke der Impedanzwandlung benötigt. Nachteilig ist außerdem, daß der Abgleichwiderstand im HF-Teil der Schaltung liegt.

Der Erfindung liegt die Aufgabe zugrunde, einen Oszillator zu schaffen, der sich mit geringerem Aufwand als die bekannten Oszillatoren realisieren läßt. Diese Aufgabe löst ein Oszillator mit den Merkmalen des Anspruches 1.

Außer dem Schwingkreis und dem Rückkopplungstransistor, der gleichzeitig als Verstärkungstransistor dient, benötigt der erfindungsgemäße Oszillator nur noch das Gegenkopplungsnetzwerk für das nur ein Widerstand und ein Kondensator notwendig ist. Die Spule braucht also keine Mittelanzapfung aufzuweisen.

Die Amplitudenbedingung für den Schwingungsfall und die notwendige Kreisverstärkung werden durch die Verluste im Schwingkreis, also die Güte Q der Schwingkreisspule entscheidend beeinflußt. Wegen dieser dominanten Abhängigkeit der Oszillatorschwingungsbedingung von der Spulengüte eignet sich der erfindungsgemäße Oszillator vorzüglich für den Einsatz in berührungslos arbeitenden, induktiven Näherungssensoren oder Näherungsschaltern.

Vorzugsweise ist die Basis des Rückkopplungstransistors über einen Widerstand mit einer Gleichspannungsquelle verbunden. Mit dieser Spannung wird der Arbeitspunkt beziehungsweise die Schwingungsbedingung eingestellt. Die Abgleichspannung oder der Abgleichwiderstand liegen also nicht im HF-Teil der Oszillatorschaltung. Hieraus resultiert ein fertigungsfreundliches, den Abgleich erleichterndes und zugleich störunempfindliches Schaltung-Layout. Darüberhinaus ermöglicht die Beeinflussung der Schwingungsbedingung mittels der Gleichspannung eine auf einfache Weise zu realisierende Regelung der Oszillator-Ausgangsspannung auf eine konstante, vom Abstand des Beeinflussungselementes unabhängige Amplitude.

Der Schwingkreis kann nur aus einer Spule bestehen, deren Wicklungskapazität die Kapazität des Schwingkreises bildet. Hierdurch läßt sich die Zahl der erforderlichen Bauelemente noch weiter reduzieren.

Bei einem berührungslos arbeitenden, induktiven Sensor oder Näherungsschalter mit dem erfindungsgemäßen Oszillator wird im einfachsten Fall die Amplitude der Oszillator-Ausgangsspannung durch eine Schmitt-Trigger-Schaltung bewertet und als binäres Schaltsignal weiterverarbeitet. Man kann das Sensor-oder Schaltsignal aber auch aus der nachgeführten Gleichspannung für die Einstellung der Schwingungsbedingung oder einer internen Spannung eines Reglers gewinnen, dem die gleichgerichtete OszillatorAusgangsspannung zugeführt wird. In einer solchen Betriebsart, bei welcher die die Schwingungsbedingung einstellende Gleichspannung geregelt wird, setzt die Oszillatorschwingung nie aus. Deshalb können hohe Schalt-Wiederholfrequenzen des Ausgangssignals erreicht werden.

Im folgenden ist die Erfindung anhand eines in der Zeichnung dargestellten Ausführungsbeispiels im einzelnen erläutert.

Es zeigen

Fig. 1 die Grundschaltung des Oszillators,

Fig. 2 das Ersatzschaltbild des Oszillators gemäß Fig. 1,

Fig. 3 das Schaltbild eines mit dem Oszillator ausgerüsteten Sensors.

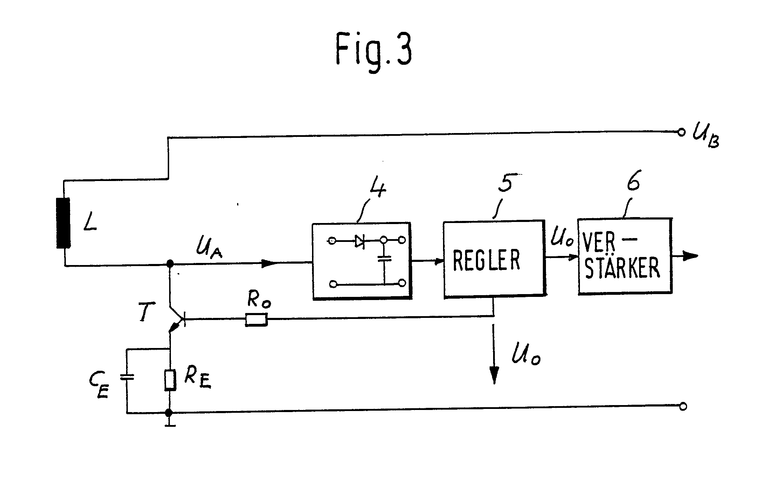

Ein Oszillator, der auch als Q-Oszillator bezeichnet werden kann, da er eine dominante Abhängigkeit der Oszillator-Schwingungsbedingung von der Spulengüte hat, weist einen als Ganzes mit 1 bezeichneten Schwingkreis auf. Dieser Schwingkreis besteht normalerweise aus einer Schwingkreisspule L und einem parallel zu dieser geschalteten Schwingkreiskondensator Cp. Die Schwingkreiskapazität kann aber auch durch die Wicklungskapazität der Schwingkreisspule L gebildet sein. Der Schwingkreis 1 besteht dann, wie Fig. 3 zeigt, nur aus der Schwingkreisspule L.

In Reihe mit dem Schwingkreis 1 liegt die Kollektor-Emitter-Strecke eines Rückkopplungs- und Verstärkungstransistors T. Mit dem Emitter des Transistors T ist ein Gegenkopplungsnetzwerk 2 verbunden, das andererseits auf Masse liegt. Im Ausführungsbeispiel besteht das Gegenkopplungsnetzwerk 2 aus einem ohmschen Widerstand $R_E$ und einem parallel zu diesem geschalteten Kondensator $C_E$.

Mit der Basis des Rückkopplungs- und Verstärkungstransistors T ist ein ohmscher Widerstand Ro verbunden, der andererseits an den einen Pol einer Gleichspannungsquelle Uo angeschlossen ist. Der andere Pol der Gleichspannungsquelle Uo ist mit Masse verbunden.

Die Betriebsspannung $U_B$ liegt zwischen Masse und dem nicht mit dem Rückkopplungs- und Verstärkungstransistor T verbundenen Pol des Schwingkreises 1. Die Oszillator-Ausgangsspannung $U_A$ wird zwischen der Verbindungsstelle des Schwingkreises 1 mit dem Rückkopplungs- und Verstärkungstransistor T sowie Masse abgegriffen. Sie ist abhängig vom Abstand eines metallischen Elementes 3 von der Schwingkreisspule L.

Die Gleichspannung Uo und der Widerstand Ro dienen der Einstellung des Arbeitspunktes beziehungsweise der Schwingungsbedingung des Oszillators.

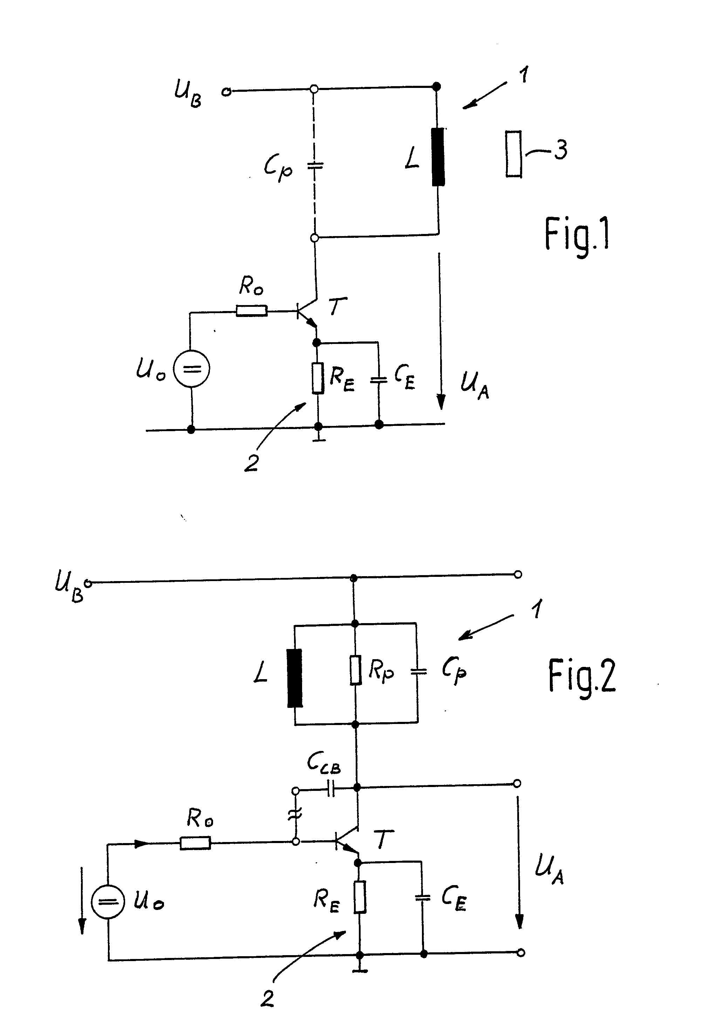

Wie Fig. 2 zeigt, lassen sich die den Oszillator beeinflussenden Verluste durch einen Verlustwiderstand Rp darstellen, der nicht nur die Verluste in der Wicklung der Schwingkreisspule L repräsentiert, sondern auch die Wirbelstromverluste im Element 3 und die Ummagnetisierungsverluste. Die Größe des Verlustwiderstandes Rp ist deshalb abhängig vom Abstand zwischen dem Element 3 und der Schwingkreisspule L.

Die Kollektor-Basis-Kapazität des Rückkopplungs- und Verstärkungstransistors T kann durch ein Kondensator $C_{CB}$ dargestellt werden. Zwischen der Kapazität dieses Kondensators und der Kollektor-Basis-Spannung besteht ein quadratischer Zusammenhang. Bei Berücksichtigung dieser Abhängigkeit und der Nichtlinearitäten ergibt sich bei einem bestimmten Verlustwiderstand Rp folgende quadratische Schwingungsbedingungsabhängigkeit zwischen der arbeitspunktbestimmenden Gleichspannung Uo und der Kapazität des Kondensators $C_E$ des Gegenkopplungsnetzwerkes:
$$Uo \geq K1 (C_E - K2)^2 + K3.$$
Dabei sind K1, K2 und K3 Konstanten, die von der Schaltungsdimensionierung abhängig sind.

Der Funktionsabgleich, zum Beispiel auf einen bestimmten Nenn-Schaltabstand zwischen dem Element 3 und der Schwingkreisspule L erfolgt durch einen Abgleich mittels der Gleichspannung Uo beziehungsweise mittels eines die Spannung Uo beeinflussenden Widerstandes.

Wie Fig. 3 zeigt, kann die gegenüber Masse zwischen der Schwingkreisspule L und dem Rückkopplungs- und Verstärkungstransistor T abgegriffen Oszillator-Ausgangsspannung $U_A$ einem Gleichrichter 4 zugeführt werden. Mit der gleichgerichteten Spannung wird ein Regler 5 beaufschlagt, der an seinen beiden Ausgängen die Gleichspannung Uo liefert. Diese Spannung wird über den Widerstand Ro zur Basis des Rückkopplungs- und Verstärkungstransistors zurückgeführt. Außerdem wird die Spannung Uo einem dem Regler 5 nachgeschalteten Verstärker 6 zugeführt. Zwischen dessen Ausgang und Masse liegt die Sensorausgangsspannung, mittels deren im Falle eines Näherungsschalters beispielsweise ein Transistor angesteuert wird. Die Betriebsspannung $U_B$ liegt an der aus der Schwingkreisspule L, dem Rückkopplungs- und Verstärkungstransistor T und dem Gegenkopplungsnetzwerk 2 bestehenden Reihenschaltung an, wobei im Ausführungsbeispiel der nicht mit dem Rückkopplungs- und Verstärkertransistor T verbundene Pol des Gegenkopplungsnetzwerkes 2 auf Masse liegt. Bei dieser geregelten Betriebsart des Oszillators setzt die Oszillatorschwingung nie aus. Deshalb können hier hohe Schalt-Wiederholfrequenzen des Ausgangssignals des Sensors erreicht werden.

Alle in der vorstehenden Beschreibung erwähnten sowie auch die nur allein aus der Zeichnung entnehmbaren Merkmale sind als weitere Ausgestaltungen Bestandteile der Erfindung, auch wenn sie nicht besonders hervorgehoben und insbesondere nicht in den Ansprüchen erwähnt sind.

## Ansprüche

1. Oszillator, insbesondere für einen berührungslos arbeitenden induktiven Näherungssensor oder Näherungsschalter, mit einem eine Induktivität und eine Kapazität aufweisenden Schwingkreis und einem Rückkopplungstransistor, dessen KollektorEmitter-Strecke in Reihe mit dem Schwingkreis liegt, dadurch gekennzeichnet, daß

a) der auch als Verstärkertransistor dienende Rückkopplungstransistor (T) zwischen dem Schwingkreis (1) und einem Gegenkopplungsnetzwerk (2) liegt,

b) die Reihenschaltung aus dem Schwingkreis (1) dem Rückkopplungstransistor (T) und dem Gegenkopplungsnetzwerk (2) zwischen den Anschlußklemmen für die Betriebsspannung ($U_B$) liegt,

c) die Basis des Rückkopplungstransistors (T) an einer den Arbeitspunkt bestimmenden Gleichspannung (Uo) liegt,

d) die Oszillator-Ausgangsspannung ($U_A$) an der Reihenschaltung aus der Kollektor-Emitter-Strecke des Rückkopplungstransistors (T) und des Gegenkopplungsnetzwerkes (2) abgegriffen wird.

2. Oszillator nach Anspruch 1, dadurch gekennzeichnet, daß das Gegenkopplungsnetzwerk (2) aus der Parallelschaltung eines ohmschen Widerstandes ($R_E$) und eines Kondensators ($C_E$) besteht.

3. Oszillator nach Anspruch 1 oder 2, dadurch gekennzeichnet, daß die Basis des Rückkopplungstransistors (T) über einen Widerstand (Ro) mit einer Gleichspannungsquelle (Uo) verbunden ist.

4. Oszillator nach einem der Ansprüche 1 bis 3, dadurch gekennzeichnet, daß die Gleichspannungsquelle (Uo) mit der auf Masse liegenden Abgriffstelle für die Oszillator-Ausgangsspannung ($U_A$) verbunden ist.

5. Oszillator nach einem der Ansprüche 1 bis 4, dadurch gekennzeichnet, daß der Schwingkreis (1), nur aus einer Spule (L) besteht, deren Wicklungskapazität die Kapazität des Schwingkreises bildet.

6. Induktiver Näherungssensor mit einem Oszillator gemäß einem der Ansprüche 1 bis 5, dadurch gekennzeichnet, daß die Oszillator-Ausgangsspannung ($U_A$) am Eingang eines Gleichrichters (4) anliegt, dem ein Regler (5) nachgeschaltet ist, dessen Ausgang über einen Widerstand (Ra) an die Basis des Rückkopplungstransistors (T) angeschlossen ist und an dem ausgangsseitig die Sensorausgangsspannung abgreifbar ist.

7. Näherungssensor nach Anspruch 6, dadurch gekennzeichnet, daß an den für den Abgriff der Sensorausgangsspannung vorgesehenen Ausgang des Reglers (5) ein Verstärker (6) angeschlossen ist, zwischen dessen Ausgang und dem vorzugsweise auf Masse liegenden Pol des Gegenkopplungsnetzwerkes (2) die Sensorausgangsspannung ansteht.

$U_B$ o——

$C_p$

$L$

$\boxed{\phantom{3}}$ — 3

1

**Fig.1**

$R_o$

$T$

$U_o$ (≡)

$R_E$   $C_E$   $U_A$

2

$U_B$ o————

$L$   $R_P$   $C_P$

1

**Fig.2**

$C_{LB}$

$R_o$

$T$

$U_o$

$R_E$   $C_E$   $U_A$

2

*EUCHNER*

*Reg. Nr. 127310*

# Fig.3

Reg.Nr. 127310

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | US-A-3 503 008 (DELIGNIERES) <br> * Spalte 4, Zeile 31 – Spalte 8, Zeile 12; Figuren 3,4 * | 1-3 | H 03 K 17/95 <br> H 03 B 5/12 |
| Y | | 5-7 | |
| Y | GB-A-2 040 054 (ELDEC CORP.) <br> * Seite 3, Zeilen 35-41; Figur 1 * <br> --- | 5 | |
| Y | FR-A-2 281 578 (TEXAS INSTRUMENTS FRANCE) <br> * Seite 1, Zeile 39 – Seite 3, Zeile 24; Figur 1 * <br> --- | 6,7 | |
| A | DE-B-1 047 265 (PHILIPS) <br> * Spalte 5, Zeilen 37-59; Figur 4 * <br> ----- | 3,4 | |

**RECHERCHIERTE SACHGEBIETE (Int. Cl.5)**

H 03 K
H 03 B

Der vorliegende Recherchenbericht wurde für alle Patentansprüche erstellt

| Recherchenort | Abschlußdatum der Recherche | Prüfer |
|---|---|---|
| DEN HAAG | 25-09-1990 | CANTARELLI R.J.H. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument